(19) Europäisches Patentamt

European Patent Office

Office européen des brevets

(11) EP 1 736 789 A1

(12) **EUROPEAN PATENT APPLICATION**
published in accordance with Art. 158(3) EPC

(43) Date of publication:
27.12.2006 Bulletin 2006/52

(51) Int Cl.:
*G01R 31/36* (2006.01)

(21) Application number: 04723322.6

(22) Date of filing: 25.03.2004

(86) International application number:
PCT/JP2004/004154

(87) International publication number:
WO 2005/093446 (06.10.2005 Gazette 2005/40)

(84) Designated Contracting States:
DE FR IT

(71) Applicants:
• NEC Lamilion Energy, Ltd.
  Kawasaki, Kanagawa 216-8555 (JP)
• FUJI JUKOGYO KABUSHIKI KAISHA
  Tokyo 160-8316 (JP)

(72) Inventor: ISHII, Mitsunori
c/o NEC Lamilion Energy Ltd.
Kawasaki-shi,
Kanagawa 2168555 (JP)

(74) Representative: Wenzel & Kalkoff
Grubesallee 26,
Postfach 73 04 66
22124 Hamburg (DE)

(54) **METHOD AND EQUIPMENT FOR ESTIMATING RESIDUAL CAPACITY OF STORAGE BATTERY**

(57) A method for determining a remaining capacity of an electric storage such as a lithium ion secondary battery which is mounted on a hybrid electric automobile or the like accurately at an arbitrary time interval includes the steps of: monitoring a charging/discharging current of the secondary battery and calculating a first remaining capacity value continuously by executing an integrating operation based on the charging/discharging current; and detecting a switching timing between charge and discharge of the secondary battery, regarding, with the timing that is detected, a terminal voltage of the secondary battery at the detected timing as an open-circuit voltage to obtain a second remaining capacity value based on the open-circuit voltage, and updating the first remaining capacity value with the second remaining capacity value.

FIG. 1

**Description**

Technical Field:

The present invention relates to a method and apparatus for estimating a remaining capacity (SOC; state of charge) of an electric storage such as various secondary batteries, e.g. a lithium ion secondary battery, and a large-capacitance capacitor.

Background Art:

In recent years, a secondary battery, such as a lithium ion secondary battery and a nickel-hydride-metal battery, has been used for electric power as a power source of driving an electric motor. Further, a large-capacitance capacitor such as an electric double layer capacitor has been used as a power source of driving an electric motor. In this description, one that stores electric energy by charge and emits the electric energy by discharge, like a secondary battery and a capacitor, is called an electric storage.

An application of such motor drive by an electric storage such as a lithium ion secondary battery and a large-capacitance capacitor, for example, is a hybrid electric automobile. A hybrid electric automobile is generally provided with an engine as an internal-combustion engine, an electric generator which is driven by the engine, an electric storage, and an electric motor.

There are various driving systems for hybrid electric automobiles. For example, there is a driving system in which drive wheels are configured to be driven by the motor, the electric storage is charged by the electric power that is obtained in the generator, and the electric power obtained by discharging the electric storage is supplied to the motor in addition to the electric power from the generator when the automobile accelerates or goes up a hill. Also, there is another system in which drive wheels are directly driven by the engine and the drive wheels are secondarily driven by the output from the motor when the automobile accelerates or goes up a hill. In these hybrid electric automobiles, in order to further improve the energy efficiency, the electric motor is operated as an electric generator and functions as a regenerative brake when the automobile is braked, and the electric storage is also charged by the obtained energy.

Generally, the hybrid electric automobile is controlled so that the remaining capacity of the electric storage is always within a predetermined range. Specifically, for example, when the remaining capacity becomes 20 % or less, the engine is started to generate electric power by the generator, the electric storage is charged by the electric power. Then, for example, when the remaining capacity becomes 80 % or more, the electric storage is not charged any more. In this way, since there is a need to control the charge/discharge in accordance with the remaining capacity of the electric storage, the remaining capacity of the electric storage must be always monitored. Specifically, the remaining capacity is obtained at a time interval from several tens of milliseconds to several seconds.

In principle, the remaining capacity of the electric storage can be obtained from a difference between an amount of electric charge that is charged and an amount of electric charge that is discharged. Therefore, conventionally, the value of the charging/discharging current of the electric storage is measured at a constant interval, and the measured values are integrated to obtain the remaining capacity of the electric storage. Further, if the electric storage is a lithium ion secondary battery or a large-capacitance capacitor, a certain relationship between an open-circuit voltage (i.e., a voltage when the charging/discharging current is zero) and the remaining capacity of the electric storage is known, and the open-circuit voltage of the electric storage is measured to estimate the remaining capacity. However, due to the reason that there is a possibility that a large current flows in a short time caused by the inrush current of the electric motor or the like when the electric storage is applied to the hybrid electric automobile and it is difficult to obtain a current sensor that is inexpensive, excellent in linearity, and accurate, there is a possibility that a nonnegligible cumulative error occurs when the remaining capacity is obtained by integrating the charging/discharging current. On the other hand, when the remaining capacity is estimated based on the open-circuit voltage of the electric storage, there is no problem of cumulative error, however, in the application for the hybrid electric automobile, timing that makes the charging/discharging current zero cannot be set at the time interval that is required to control the charge/discharge based on the remaining capacity, *i.e.,* the open-circuit voltage cannot be obtained at such a time interval, and thus there is a problem that the remaining capacity value cannot be obtained by this method in practice.

Japanese Patent Laid-Open Publication No. 11-206028 (JP-A-11-206028) discloses that, while the remaining capacity is obtained by integrating the charging/discharging current to the electric storage, a charging/discharging I-V (current-voltage) characteristic curve of the electric storage is obtained from terminal voltage values and charging/discharging current values before and after switching when switching from charge to discharge or from discharge to charge, the open-circuit voltage is estimated from the charging/discharging I-V characteristic curve, and the remaining capacity is obtained in accordance with the estimated open-circuit voltage. Then, the remaining capacity obtained by integrating the charging/discharging current and the remaining capacity obtained from the estimated open-circuit voltage are compared, and the remaining capacity obtained by integrating the charging/discharging current is replaced with the remaining capacity obtained from the estimated open-circuit voltage when the difference is not less than a predetermined value. However, this method has the problem that operations for obtaining the charging/discharging I-V characteristic curve are required and the amount of operations is large, and the accuracy of the obtained remaining capacity is not very good since the open-circuit is just an estimated value.

Incidentally, when an electric storage, such as a lithium ion secondary battery and a large-capacitance capacitor, is used, the cells of these electric storages are hardy used alone, and they are generally used as an electric storage pack in which a plurality of cells is connected in series and/or in parallel in order to obtain a desired discharging voltage and a desired discharging current. The electric storage pack is often provided with a safety circuit, such as a circuit preventing from overcharging, and a circuit for measuring a remaining capacity and outputting the measured value in addition to electric storage cells (battery cells, capacitor cells).

As described above, the conventional method of determining the remaining capacity of the electric storage still has the problem that the error is large, the updated remaining capacity value cannot be obtained at a required time interval, and the amount of operations becomes large.

Disclosure of Invention:

It is an object of the present invention to provide a remaining capacity estimating method that can estimate an updated remaining capacity of an electric storage at a desired time interval accurately with a small amount of operations.

It is another object of the present invention to provide a remaining capacity estimating apparatus that can estimate an updated remaining capacity of the electric storage at a desired time interval accurately with a small amount of operations.

It is a further object of the present invention to provide an electric storage pack into which such an estimating apparatus is incorporated.

The first object of the present invention is attained by a method for estimating a remaining capacity of an electric storage, comprising the steps of: monitoring a charging/discharging current of the electric storage and calculating a first remaining capacity value continuously by executing an integrating operation, based on the charging/discharging current; detecting a switching timing between charge and discharge of the electric storage battery, determining, with said timing that is detected, a second remaining capacity value based on a terminal voltage of the electric storage at the timing to update the first remaining capacity value with the second remaining capacity value; and continuing the integrating operation based on the first remaining capacity value that is updated and regarding the first remaining capacity value as the remaining capacity of the electric storage.

The second object of the present invention is attained by an apparatus for estimating a remaining capacity of an electric storage, comprising: current detecting means for detecting a charging/discharging current of the electric storage; voltage measuring means for detecting a terminal voltage of the electric storage; storing means for holding a value of the remaining capacity; operating means for continuously executing an integrating operation to the value stored in the storing means based on the charging/discharging current that is detected; timing detecting means for detecting a switching timing between charge and discharge of the electric storage based on an output of the current detecting means; and remaining capacity value acquiring means for obtaining a remaining capacity value based on the terminal voltage with the timing that is detected, wherein the value in the storing means is updated with the remaining capacity value obtained by the remaining capacity value acquiring means with the timing that is detected.

The third object of the present invention is attained by an electric storage pack comprising: a current detector that detects a charging/discharging current of an electric storage; a voltage measuring device that detects a terminal voltage of the electric storage; a storing unit that holds and outputs a value of a remaining capacity; an operating unit that executes an integrating operation continuously to the value stored in the storing unit based on the charging/discharging current that is detected; a timing detector that detects a switching timing between charge and discharge' of the electric storage based on an output of the current detector; and a remaining capacity value acquiring unit that obtains a remaining capacity value based on the terminal voltage with the timing that is detected, wherein the value in the storing unit is updated with the remaining capacity value obtained by the remaining capacity value acquiring unit with the timing that is detected.

The present invention focuses attention on that, in the application of a hybrid electric automobile or the like, charge and discharge are often switched in the electric storage, the direction of the current flowing through the electric storage changes, the charging/discharging current becomes zero instantaneously while the direction is changing, and therefore the open-circuit voltage of the electric storage can be obtained by measuring the terminal voltage of the electric storage with this timing. When the open-circuit voltage of the electric storage can be obtained, the remaining capacity can be estimated accurately, as described above. However, since the switching interval between charge and discharge is not constant, in the hybrid electric automobile, there is a possibility that the interval is about one second when short and several-ten minutes when longest, the interval is too long to control charge and discharge based on the remaining capacity and cannot be used as it is. Then, according to the present invention, white the remaining capacity is continuously calculated by integrating the charging/discharging current, for example, the charge and discharge is controlled by the first remaining capacity value thus obtained, and the first remaining capacity value by integrating the charging/discharging current is rewritten by the remaining capacity based on the open-circuit voltage measured with the timing, *i.e.*; the second remaining capacity value, whenever the switching between charge and discharge occurs. After that, the integrating operation of the charging/discharging current is executed based on the rewritten first remaining capacity value until subsequent switching between charge and discharge occurs:

With this arrangement, according to the present invention, whenever the switching between charge and discharge occurs in the electric storage, the first remaining capacity value by integrating the charging/discharging current is updated with the second remaining capacity that is more accurate based on the open-circuit voltage, and therefore the cumulative error in integrating of the charging/discharging current is reset on each occasion. Therefore, in the present invention, the remaining capacity can be obtained with less effect of the cumulative error and with accuracy, and further at an arbitrary timing. When considerations are given to the application in a hybrid electric automobile, the switching between charge and discharge occurs after several ten minutes pass at longest, the remaining capacity value is updated with the accurate value based on the open-circuit voltage, and therefore, the cumulative error by integrating the charging/discharging current during this period does not become large to give adverse effects on the charge/discharge control by the remaining capacity. Also, according to the present invention, it is unnecessary to use an expensive sensor that is excellent in linearity as the current sensor used to detect the charging/discharging current, and the cost as the entire arrangement for estimating the remaining capacity can be reduced.

In the present invention, for example, a secondary battery such as a lithium ion secondary battery and a nickel-hydride-metal battery, and a large-capacitance capacitor such as an electric double layer capacitor may be used as an electric storage.

Brief Description of the Drawings:

FIG. 1 is a block diagram showing a configuration of a remaining capacity estimating apparatus according to an embodiment of the present invention.
FIG. 2A is a circuit diagram showing an example of a configuration of a polarity detecting unit.
FIG. 2B is a waveform diagram for explaining an operation of the polarity detecting unit.
FIG. 3 is a view schematically showing an operation of remaining capacity estimation.
FIG. 4 is a flowchart for explaining the operation of the remaining capacity estimation.
FIG. 5 is a block diagram showing a configuration of a remaining capacity estimating equipment according to another embodiment of the present invention.

Best Mode for Carrying Out the Invention:

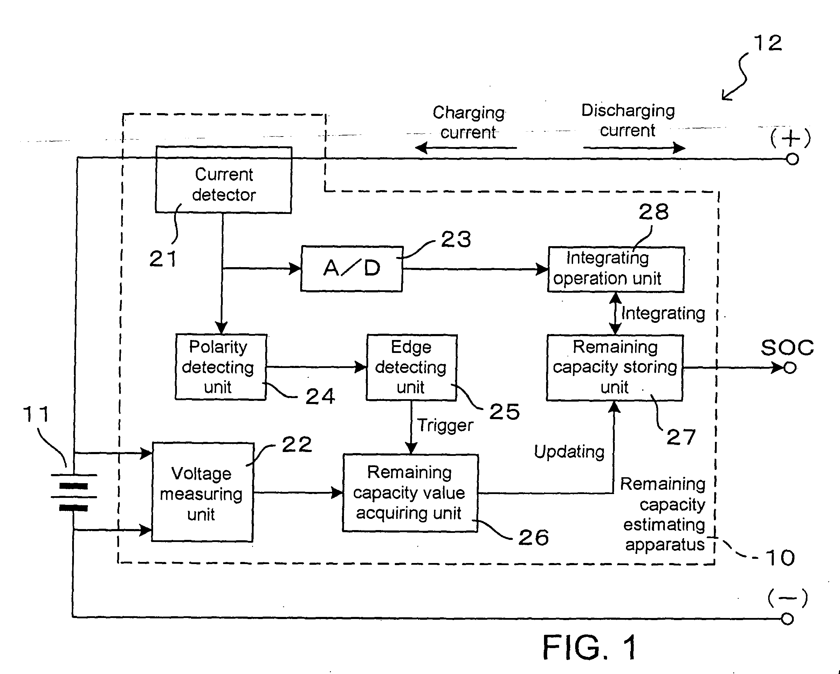

Figure 1 which illustrates the configuration of the remaining capacity estimating apparatus for an electric storage according to one embodiment of the present invention is drawn in a manner that remaining capacity estimating apparatus 10 is incorporated into an electric storage pack. In this embodiment, secondary battery 11, such as, for example, a lithium ion secondary battery, is used as the electric storage, and therefore, the electric storage pack is configured as battery pack 12.

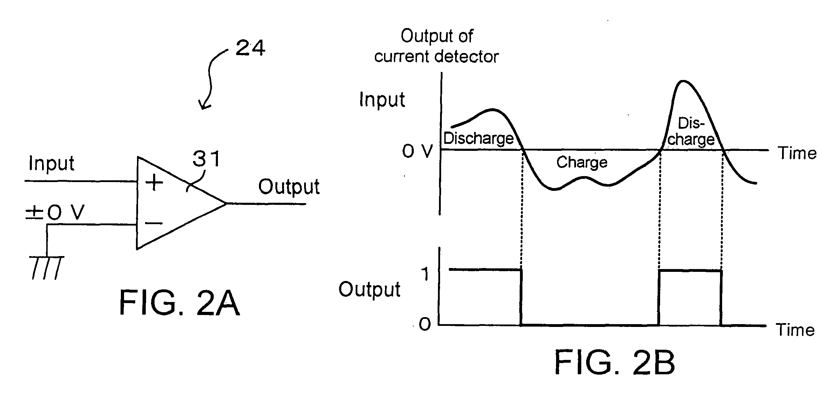

Remaining capacity estimating apparatus 10 is provided with current detector 21 that detects a charging current and a discharging current to secondary battery 11, voltage measuring unit 22 that measures and outputs the terminal voltage of secondary battery 11, A/D converter 23 that samples the output from current detector 21 and executes analog-to-digital conversion, polarity detecting unit 24 that shapes the output waveform from current detector 21 and detects the polarity of the charging/discharging current, edge detecting unit 25 that detects an edge in the output of polarity detecting unit 24 and outputs a trigger signal, remaining capacity value acquiring unit 26 that acquires a remaining capacity value based on an open-circuit voltage of secondary battery 11 (lithium ion secondary battery in the present embodiment), remaining capacity storing unit 27 that holds a current value of the remaining capacity, and integrating operation unit 28 that executes an integrating operation to the remaining capacity value held by remaining capacity storing unit 27 based on the output from A/D converter 21. One example of the internal configuration of polarity detecting unit 24 is shown in FIG. 2A. The polarity of the charging/discharging current indicates a distinction whether the current flowing through electric storage 11 is a charging current or a discharging current.

Specifically, an open-loop type current detector that uses a hole sensor, or a detector that has a shunt resistor and measures the voltages across both ends thereof may be used as current detector 21. Current detector 21 generates a voltage that is proportional to the amount of the charging/discharging current and, for example, is negative when the current is the charging current and is positive when the discharging current. The difference between the charging current and the discharging current is distinguished by the direction of the current to secondary battery 11. Polarity detecting unit 24, for example, is configured to distinguish whether discharge or charge based on that the output from current detector 21 is negative or positive, to output "1" by the logical, Level during the discharge period, and to output "0" during the charge period, as shown in FIG. 2B. As such polarity detecting unit 24, as shown in FIG. 2A, a detector having comparator 31 may be used. The waveform from current detector 21 is supplied into a non-inverted (+) terminal of comparator 31, and 0 V is supplied to a inverted (-) terminal as a reference potential Edge detecting unit 25 outputs a trigger signal in a rising edge of the output from polarity detecting unit 24, *i.e.,* an edge where the output state is changed from "0" to "1" and in a tailing edge, *i.e.,* an edge where the output state is changed from "1" to "0".

Remaining capacity value acquiring unit 26, when receiving the open-circuit voltage of secondary battery 11, obtains and outputs a remaining capacity corresponding to the open-circuit voltage. In the present embodiment, remaining capacity value acquiring unit 26 receives a voltage value that is a digital value measured In voltage measuring unit 22 and the trigger signal generated in edge detecting unit 25. Then, remaining capacity value acquiring unit 26 acquires the voltage value with timing that the trigger signal is input, and outputs the remaining capacity value corresponding to the acquired voltage value. In fact, remaining capacity value acquiring unit 26 is provided with a look-up table (LUT) showing the relationship between the open-circuit voltage value, and the remaining capacity of the lithium ion secondary battery, refers to the look-up table while regarding the acquired Voltage value as an open-circuit voltage value, and outputs the remaining capacity value. When the electric storage to be a subject of remaining capacity estimation is an electric storage except the lithium ion secondary battery, the look-up table corresponding to the characteristic of the electric storage may be provided. Needless to say, when the relationship between the open-circuit voltage and the remaining capacity is represented by a simple function formula, like a case where the electric storage is largo-capacitance capacitor, the remaining capacity may be obtained by calculation based on the function formula.

Remaining capacity storing unit 27 that holds the current remaining capacity of secondary battery 11 also functions as an operation memory for the remaining capacity operation by integrating the charging/discharging current with integrating operation unit 28. The current remaining capacity (SOC) is delivered from remaining capacity storing unit 27 to an outside at real time. Further, the remaining capacity value in remaining capacity storing unit 27 is updated with the value output from remaining capacity value acquiring unit 26 when the trigger signal is output and the remaining capacity value is output from remaining capacity value acquiring unit 26.

integrating operation unit 28 executes an integrating operation to the remaining capacity value stored in remaining capacity storing unit 28 in accordance with the output from A/D converter 23 whenever A/D converter 23 performs sampling. Here, when the remaining capacity value stored in remaining capacity storing unit 27 is represented by [SOC], in discharging, [SOC] is updated by

$$[SOC] \leftarrow [SOC] - (\text{magnitude of discharging current}) \qquad \cdots (1)$$

and, in charging, [SOC] is updated by

$$[SOC] \leftarrow [SOC] + (\text{magnitude of charging current}) \times (\text{charge efficiency}) \qquad \cdots (2).$$

When the sampling in A/D converter 23 is executed at a constant cycle, the addition and subtraction for the current amount are equivalent to the addition and subtraction for the electric charge amount. In this equation, the charge efficiency is multiplied, because the entire electric charge amount corresponding to the charging current is not efficiently stored in secondary battery 11. The charge efficiency is generally a function of temperature. Therefore, the temperature may be measured, and the charge efficiency value may be varied in accordance with the temperature to execute the integrating operation.

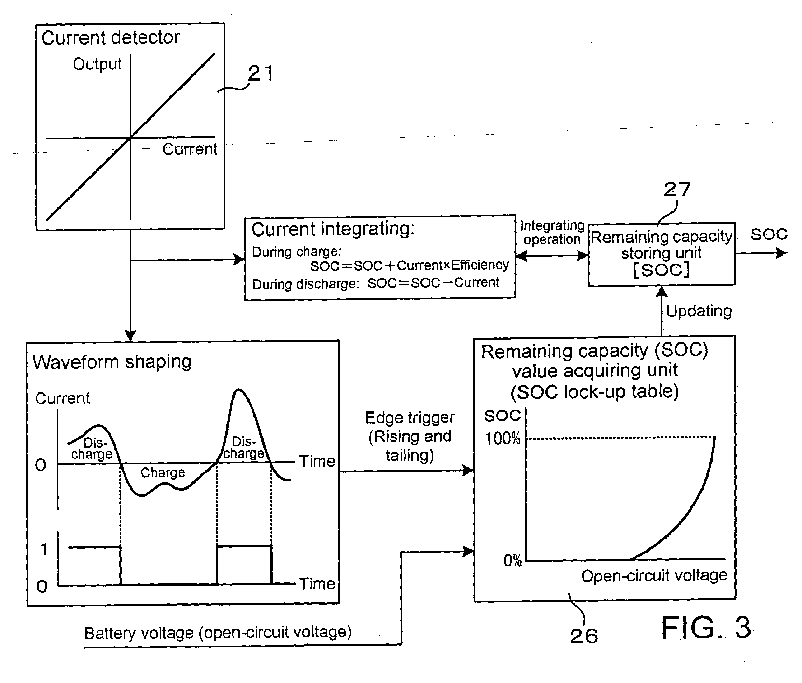

Figure 3 schematically shows the operation of remaining capacity estimating apparatus 10.

Current detector 21 always monitors the charging/discharging current to secondary battery 11 which is an electric storage, and supplies a voltage signal corresponding to the detected current to A/D converter 23 and polarity detecting unit 24. A/D converter 23 and integrating operation unit 28 execute the integrating operation by executing the addition or subtraction of the charging/discharging current to/from the remaining capacity value [SOC] stored in remaining capacity storing unit 27 in accordance with the above equation (1), (2) whenever A/D converter 23 performs sampling. Accordingly, an updated remaining capacity value is stored in remaining capacity storing unit 27 whenever A/D converter performs sampling.

The voltage signal from current detector 21 is also supplied into polarity detecting unit 24 and the waveform is shaped therein to provide a signal that the logical level is "1" during the discharge period and "0" during the charge period. After that, edge detecting unit 25 detects both edges, *i.e.*, the rising edge and the tailing edge of the signal. Remaining capacity value acquiring unit 26 acquires the remaining capacity value corresponding to the terminal voltage of secondary battery 11 , timing that the trigger signal is supplied from edge detector 25, *i.e.*, timing that an edge trigger is applied, and updates the remaining capacity value [SOC] stored in remaining capacity storing unit 27 with the acquired remaining capacity value. The timing that the edge trigger is applied is timing at which secondary battery 11 is changed from charge to discharge or from discharge to charge. Since the charging/discharging current of secondary battery 11 is substantially 0 at this time, the terminal voltage of secondary battery 11 is regarded as the open-circuit voltage of secondary battery 11 at that time. After all, remaining capacity value acquiring unit 26 outputs an accurate remaining capacity value based on the open-circuit voltage with timing for switching from charge to discharge or from discharge to charge. Therefore, according to remaining capacity estimating apparatus 10, the remaining capacity of secondary battery 11 is continuously calculated by the integrating operation of the charging/discharging current, and the remaining capacity value that is used for the integrating operation is updated with an accurate remaining capacity value with the switching timing between charge and discharge. With this operation, the accumulation of errors in the integrating operation is eliminated, and an accurate remaining capacity can be known at an arbitrary time

Remaining capacity estimating apparatus 10, which is described above, is generally implemented .by using a microprocessor (MPU). In this case, each function of edge detecting unit 25, remaining capacity value acquiring unit 26, remaining capacity storing unit 27, and integrating operation unit 28 is carried out by the microprocessor. Specifically, the microprocessor continuously executes the integrating operation by the charging/discharging current, the output signal from waveform shaping unit 24 may be supplied to the input capture terminal of the microprocessor to detect the rising edge and the tailing edge, an interrupt task may be generated to refer to the look-up table of the remaining capacity value when the edge is detected.

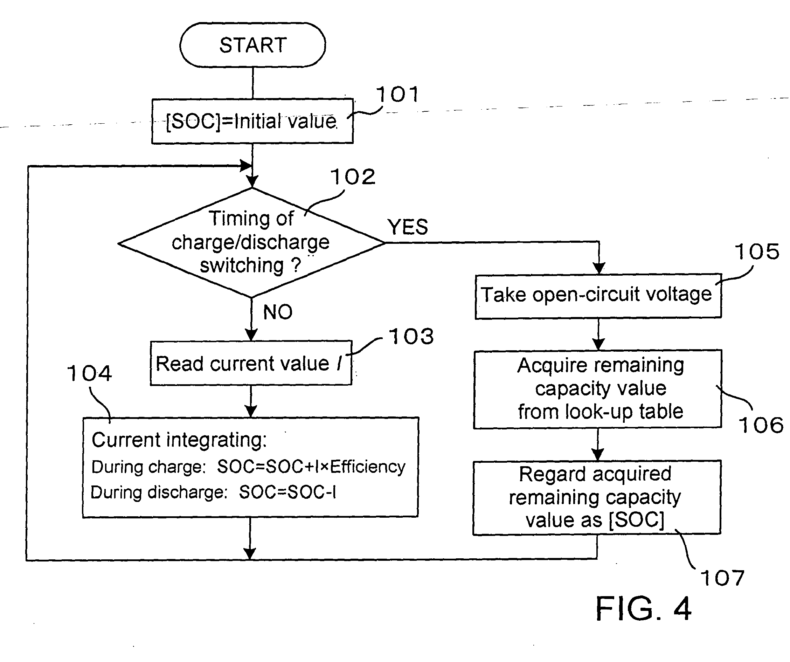

Figure 4 is a flowchart showing an example of the operation of such a microcomputer. First, in step 101, an initial value is substituted into remaining capacity value [SOC] in remaining capacity storing unit 27 as initialization, and, in step 102, it is determined whether or not the timing of charge/discharge switching, *i.e.*, the edge is detected. When the timing is not switched, in step 103, current value *I* is read from A/D converter 23, and in step 104, [SOC] is updated by the integrating operation of the charging/discharging current, and the process is returned to step 102. When the timing is switched in step 102, since the interrupt task is generated, as described above, in step 105, the open-circuit voltage is taken, in step 106, the remaining capacity value is acquired from the look-up table, in step 107, the acquired remaining capacity value is substituted into [SOC], and the process is returned to step 102.

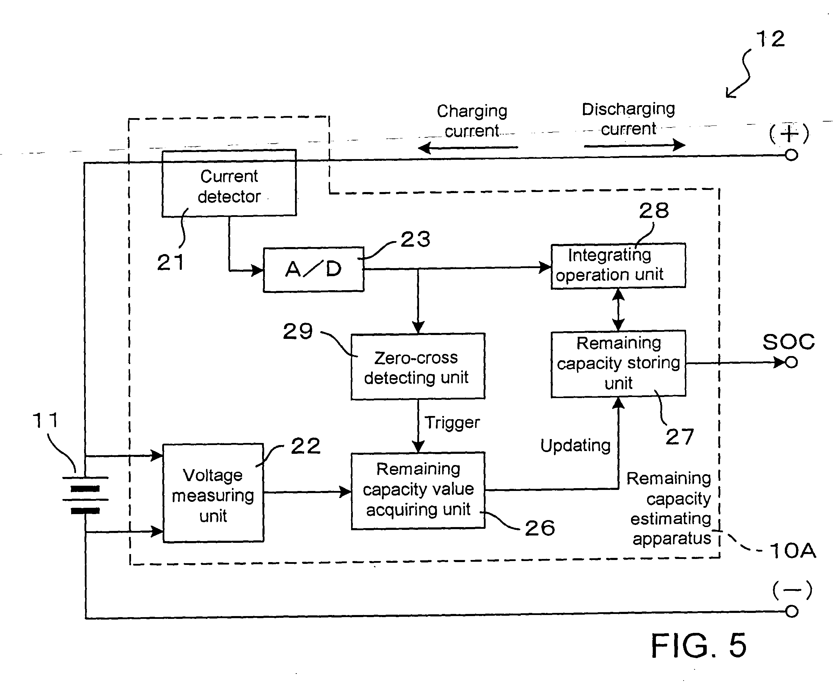

In the remaining capacity estimating apparatus shown in FIG. 1, polarity detecting unit 24 and edge detecting unit 25 are used to detect the switching timing between charge and discharge in secondary battery 11, however, the present invention is not limited to this. When the sampling rate of A/D converter 23 is sufficiently fast, the switching timing between charge and discharge can be detected from the output from A/D converter 23. Figure 5 shows the configuration of such a remaining capacity estimating apparatus. Remaining capacity estimating apparatus 10A is provided with zero-cross detecting unit 29 instead of polarity detecting unit 24 and edge detecting unit 25 in the remaining capacity estimating apparatus shown in FIG. 1. Zero-cross detecting unit 29 monitors the output from A/D converter 23 and outputs a trigger signal to remaining capacity value acquiring unit 26 with timing that the output value from A/D converter 23 is switched from positive to negative or from negative to positive. In the usual case, since the most significant bit (MSB) in the digital values output from A/D converter 23 is a sign bit, switching between "0" and "1" in the sign bit is detected, thereby detecting the switching between positive and negative in the output from A/D converter 23.

### Claims

1. A method for estimating a remaining capacity of an electric storage, comprising the steps of:

    monitoring a charging/discharging current of the electric storage and calculating a first remaining capacity value continuously by executing an integrating operation based on the charging/discharging current;
    detecting a switching timing between charge and discharge of the electric storage, and determining, with said timing that is detected, a second remaining capacity value based on a terminal voltage of said electric battery at said timing to update the first remaining capacity value with the second remaining capacity value; and
    continuing said integrating operation based on the first remaining capacity value that is updated and regarding said first remaining capacity value as the remaining capacity of the electric storage.

2. The method according to Claim 1, wherein said electric storage is a lithium ion secondary battery.

3. The method according to Claim 1, further comprising a step of referring to a look-up table that indicates a relationship between an open-circuit voltage and a remaining capacity of said electric storage and obtaining said second remaining capacity value.

**4.** The method according to Claim 3, wherein said electric storage is a lithium ion secondary battery.

**5.** An apparatus for estimating a remaining capacity of an electric storage, comprising:

current detecting means for detecting a charging/discharging current of said electric storage;
voltage measuring means for detecting a terminal voltage of said electric storage;
storing means for holding a value of said remaining capacity;
operating means for continuously executing an integrating operation to the value stored in said storing means based on said charging/discharging current that is detected;
timing detecting means for detecting a switching timing between charge and discharge of said electric storage based on an output of said current detecting means; and
remaining capacity value acquiring means for obtaining a remaining capacity value based on said terminal voltage with said timing that is detected,
wherein said value in said storing means is updated with the remaining capacity value obtained by said remaining capacity value acquiring means with said timing that is detected.

**6.** The apparatus according to Claim 5, wherein the remaining capacity of the electric storage that is a lithium ion secondary battery is estimated.

**7.** The apparatus according to Claim 5, wherein said remaining capacity value acquiring means has a look-up table indicating a relationship between an open-circuit voltage and the remaining capacity value of said electric storage and refers to said look-up table based on said terminal voltage to obtain said remaining capacity value.

**8.** The apparatus according to Claim 7, wherein the remaining capacity of the electric storage that is a lithium ion secondary battery is estimated.

**9.** An electric storage pack comprising:

an electric storage;
a current detector that detects a charging/discharging current of said electric storage;
a voltage measuring device that detects a terminal voltage of said electric storage;
a storing unit that holds and outputs a value of said remaining capacity;
an operating unit that executes an integrating operation continuously to the value stored in said storing unit based on said charging/discharging current that is detected;
a timing detector that detects a switching timing between charge and discharge in said electric storage based on an output of said current detector; and
a remaining capacity value acquiring unit that obtains a remaining capacity value based on said terminal voltage with said timing that is detected,
wherein said value in said storing unit is updated with the remaining capacity value obtained by said remaining capacity value acquiring unit with said timing that is detected.

**10.** The electric storage pack according to Claim 9, wherein said electric storage is a lithium ion secondary battery.

**11.** The electric storage pack according to Claim 9, wherein a look-up table indicating a relationship between an open-circuit voltage and a remaining capacity value of said electric storage is provided in said remaining capacity value acquiring unit, and said look-up table is referred in accordance with said terminal voltage to obtain said remaining capacity value.

**12.** The electric storage pack according to Claim 11, wherein said electric storage is a lithium ion secondary battery.

FIG. 1

EP 1 736 789 A1

Input ———————— +

±0 V ———————— −

31

Output

**FIG. 2A**

24

Output of
current detector

Input

Discharge

0 V ————————————————— Time

Charge

Dis-
charge

Output

1

0

Time

**FIG. 2B**

EP 1 736 789 A1

**Current detector**

Output

Current

21

**Current integrating:**

During charge:
    SOC=SOC+Current×Efficiency

During discharge:  SOC=SOC−Current

Integrating operation

27

**Remaining capacity storing unit [SOC]**

SOC

Updating

**Waveform shaping**

Current

Dis-charge

Charge

Dis-charge

Time

0

1

0

Time

Edge trigger (Rising and tailing)

**Remaining capacity (SOC) value acquiring unit (SOC lock-up table)**

SOC

100%

0%

Open-circuit voltage

26

Battery voltage (open-circuit voltage)

FIG. 3

FIG. 4

FIG. 5

## EP 1 736 789 A1

## INTERNATIONAL SEARCH REPORT

| | International application No. |
|---|---|
| | PCT/JP2004/004154 |

### A. CLASSIFICATION OF SUBJECT MATTER
Int.Cl⁷ G01R31/36

According to International Patent Classification (IPC) or to both national classification and IPC

### B. FIELDS SEARCHED
Minimum documentation searched (classification system followed by classification symbols)
Int.Cl⁷ G01R31/36

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2004 |
| Kokai Jitsuyo Shinan Koho | 1971-2004 | Toroku Jitsuyo Shinan Koho | 1994-2004 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X<br>Y | JP 2001-147260 A (Honda Motor Co., Ltd.),<br>29 May, 2001 (29.05.01),<br>Par. Nos. [0007] to [0010], [0012],<br>[0022] to [0024], [0031] to [0036];<br>all drawings<br>(Family: none) | 1,3,5,7,9,11<br>2,4,6,8,10,<br>12 |
| Y | JP 11-135159 A (Japan Storage Battery Co.,<br>Ltd.),<br>21 May, 1999 (21.05.99),<br>Par. Nos. [0010], [0028]<br>(Family: none) | 2,4,6,8,10,<br>12 |

☐ Further documents are listed in the continuation of Box C.   ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>06 July, 2004 (06.07.04) | Date of mailing of the international search report<br>20 July, 2004 (20.07.04) |
|---|---|
| Name and mailing address of the ISA/<br>Japanese Patent Office | Authorized officer |
| Facsimile No. | Telephone No. |

Form PCT/ISA/210 (second sheet) (January 2004)

13

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 11206028 A